# EUROPEAN PATENT APPLICATION

(11) **EP 4 498 422 A1**
(43) Date of publication of application: **29.01.2025**
(21) Application number: 24188563.1
(22) Date of filing: 15.07.2024
(51) Int. Cl.: H01L 21/8252, H01L 21/761, H01L 27/085, H01L 21/8258, H01L 27/06

(54) **SEMICONDUCTOR ELECTRONIC DEVICE COMPRISING AN ELECTRONIC COMPONENT BASED ON HETEROSTRUCTURE AND MANUFACTURING PROCESS**

(30) Priority: 27.07.2023 IT 202300015852
(71) Applicant: STMicroelectronics International N.V., 1228 Plan-les-Ouates, Geneva (CH)
(72) Inventor: DEPETRO, Riccardo, 28845 DOMODOSSOLA (VB) (IT)
(74) Representative: Studio Torta S.p.A.

(57) **Abstract**

A semiconductor electronic device (1) is formed in a die (3) having a substrate (15) of semiconductor material of a first conductivity type (P). The device has a first electronic component (5A, 5B) based on heterostructure, which has a body structure (20, 70) of semiconductor material that extending, in the die, on the substrate (15), and an epitaxial multilayer (21, 71) extending in contact with the body structure and having a heterostructure (22, 72). The body structure of the first electronic component has a first doped region (25, 27, 75, 77) of semiconductor material that extends between the heterostructure and the substrate and has a second conductivity type (N) different from the first conductivity type.

## Description

### Technical field

The present invention relates to a semiconductor electronic device comprising an electronic component based on heterostructure and to the manufacturing process.

### Background

Semiconductor electronic devices are known that comprise electronic components based on heterostructure, for example HEMTs (High-Electron-Mobility Transistors).

In practice, operation of such electronic components is based upon the electronic properties of a heterojunction between two different semiconductor materials.

In detail, in HEMTs, the conductive channel is based upon formation of layers of two-dimensional electron gas (2DEG) with high-mobility electrons that form at a heterojunction, i.e., at the interface between semiconductor materials that have different band gaps. For instance, HEMTs are known based upon the heterojunction between a layer of aluminium and gallium nitride (AlGaN) and a layer of gallium nitride (GaN).

HEMTs, in particular HEMTs based upon AlGaN/GaN heterojunctions or heterostructures, offer a wide range of advantages that render them particularly suited and widely used for different applications. For instance, the high-breakdown threshold of HEMTs is exploited for high-performance power switches; the high mobility of the electrons in the conductive channel enables to obtain highfrequency amplifiers; further, the high concentration of electrons in the 2DEG allows to obtain a low ON-state resistance (R_{ON}).

Further, HEMTs for radiofrequency (RF) applications typically provide better RF performance than similar silicon LDMOS devices.

The above electronic devices are obtained starting from a <111> silicon wafer, or else from a substrate of sapphire (Al₂O₃) or silicon carbide, and the electronic components based on heterostructure are integrated in a heterostructure grown epitaxially on the wafer.

However, known electronic components based on heterostructure have electrical performance that depends, in use, upon the operating conditions of the electronic device itself. Consequently, the corresponding electronic device has a low reliability.

For instance, the ON-state resistance of known HEMTs has, in use, a high variability; for example, it may increase by a value comprised between 50% and 200% of the design value, especially when the HEMT is used as high-side switch in a circuit in source-follower configuration.

### Summary

According to the present invention, a semiconductor electronic device and a manufacturing process are thus provided, as defined in the annexed claims.

### Brief description of the drawings

For a better understanding of the present invention, embodiments thereof are now described, purely by way of non-limiting example, with reference to the attached drawings, wherein:
- Figure 1 shows a top plan view of a semiconductor electronic device according to one embodiment;
- Figure 2 is a cross-sectional view of the electronic device of Figure 1, along a section line II-II;
- Figure 3 shows an electrical equivalent of a portion of the electronic device of Figure 1, according to one embodiment; and
- Figures 4A-4H show cross-sections of a portion of the device of Figure 2, in successive manufacturing steps.

### Description of embodiments

The following description refers to the arrangement illustrated in the attached figures. Consequently, terms such as "above", "underneath", "top", "bottom", "right", "left", "high", "low", and the like, regard the annexed figures and are not to be interpreted in a limiting way.

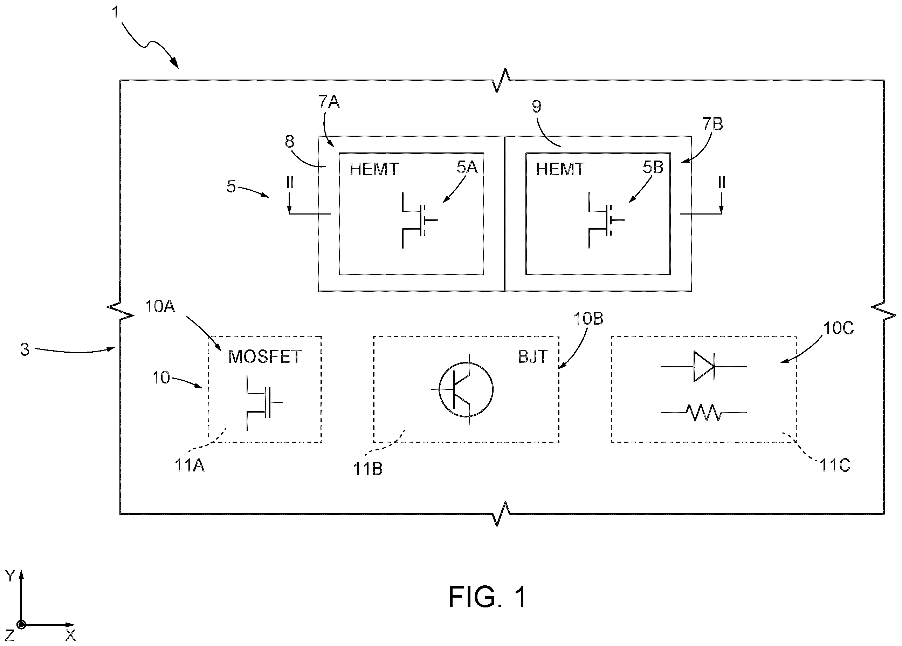

Figure 1 shows a semiconductor electronic device (referred to hereinafter simply as device) 1, in a cartesian reference system XYZ having a first axis X, a second axis Y, and a third axis Z.

The device 1 comprises a die 3 and one or more electronic components based on heterostructure 5, of which a first HEMT 5A and a second HEMT 5B are illustrated in Figure 1, integrated in the die 3.

The die 3 is obtained after a step of dicing of a semiconductor wafer.

The first HEMT 5A is integrated in an active area 7A of the die 3, which is laterally delimited by a respective insulation structure 8.

The second HEMT 5B is integrated in an active area 7B of the die 3, which is distinct from the active area 7A and is laterally delimited by a respective insulation structure 9.

Optionally, the device 1 may also comprise one or more silicon-based electronic components, for example of an active or passive type, which are also integrated in the die 3. For instance, as illustrated in the embodiment of Figure 1, the device 1 may comprise one or more MOSFETs 10A, one or more BJTs 10B, and/or one or more passive components 10C, such as diodes and resistors.

In practice, operation of the silicon-based electronic components is based upon the electronic properties of a single semiconductor material, in particular silicon.

In Figure 1, as indicated by the dashed lines, the MOSFETs 10A, the BJTs 10B, and the passive components 10C are each integrated in a respective active area 11A, 11B, 11C of the die 3.

The active areas 11A, 11B, 11C may be electrically insulated from one another or in electrical contact with one another, according to the specific application of the device 1.

For instance, the active areas 11A, 11B, 11C may be electrically insulated from one another via BCD (Bipolar-CMOS-DMOS) technology.

In the embodiment of Figure 1, the active areas 11A, 11B, 11C are arranged on the outside of the insulation structures 8, 9. However, one or more of the silicon-based electronic components 10 may be integrated in the active areas 7A and/or 7B, according to the specific application.

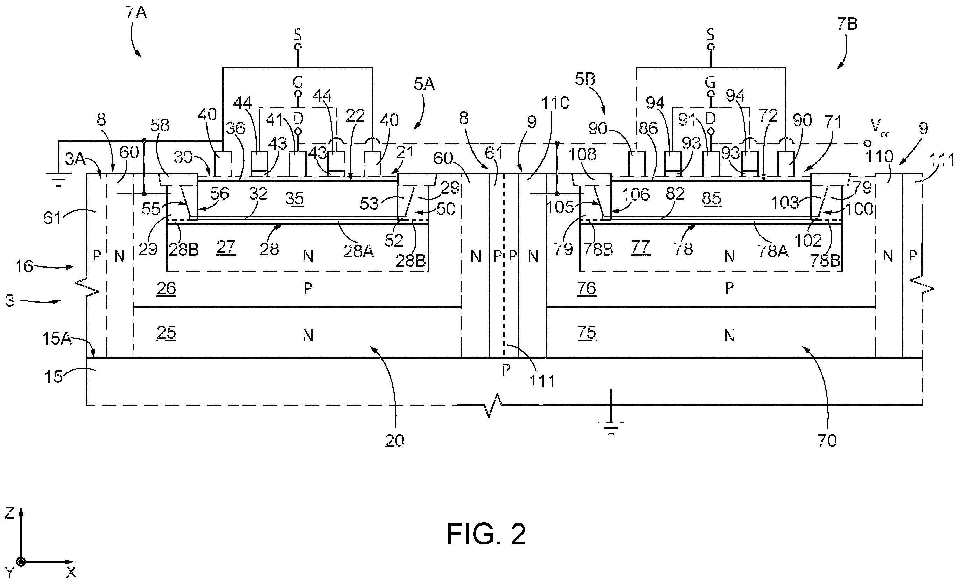

With reference to the cross-section of Figure 2, the die 3 comprises a substrate 15 and a device region 16 that extends on the substrate 15 and wherein the heterostructure-based components 5 and, if present, the silicon-based components 10 are integrated.

The active area 7A forms a first front surface 3A of the die 3.

The substrate 15 is of semiconductor material, in particular monocrystalline semiconductor material, and has a top surface 15A.

In detail, in this embodiment, the substrate 15 is of monocrystalline silicon and, in particular, the top surface 15A is oriented according to the crystallographic direction <111>.

The substrate 15 is, in this embodiment, of P type and has a resistivity comprised, for example, between 0.1 Ω·cm and 20 Ω·cm.

The first HEMT 5A comprises: a body structure 20 of semiconductor material that extends in the die 3, within the active area 7A, on the substrate 15; and an epitaxial multilayer 21 in contact with the body structure 20 and comprising a heterostructure 22 configured to house a layer of two-dimensional gas of charge carriers.

In practice, the epitaxial multilayer 21 is a heteroepitaxial multilayer grown starting from the body structure 20.

The body structure 20, here of silicon, may be of monocrystalline type, in particular having the same crystallographic orientation as the substrate 15.

The body structure 20 comprises at least one doped region that has a type of conductivity different from that of the substrate 15 and is arranged between the heterostructure 22 and the substrate 15, in particular underneath the heterostructure 22 and facing the latter.

In this embodiment, the body structure 20 comprises a plurality of doped regions, referred to in what follows as: first epitaxial region 25; second epitaxial region 26; third epitaxial region 27; fourth epitaxial region 28; and fifth epitaxial region 29.

The epitaxial regions 25-29 may be formed by one or more epitaxial layers grown on the substrate 15, according to the specific application.

The first epitaxial region 25 has a type of conductivity different from that of the substrate 15; i.e., here it is of an N type.

The first epitaxial region 25 is arranged, parallel to the third axis Z, underneath the epitaxial multilayer 21. In other words, the first epitaxial region 25 faces the epitaxial multilayer 21, at a distance therefrom in the embodiment of Figure 2.

The first epitaxial region 25 may be a region buried in the die 3.

In detail, the first epitaxial region 25 extends in direct contact with the substrate 15.

In practice, the body structure 20 is delimited underneath, i.e., along the third axis Z in the direction of the substrate 15, by the first epitaxial region 25.

The first epitaxial region 25 may have a doping level that is uniform or variable along the first axis, the second axis, and/or the third axis Z, for example so as to have a resistivity comprised between 0.02 Ω·cm and 20 Ω·cm, for instance with a doping level comprised between 8·10¹⁴ atoms/cm³ and 5·10¹⁹ atoms/cm³.

In particular, the first epitaxial region 25 may have a peak doping level that is higher than the peak doping level of the substrate 15. This may enable, in use, having a depleted region between the first epitaxial region 25 and the substrate 15 that extends mainly in the substrate 15.

The second epitaxial region 26 extends on the first epitaxial region 25.

In detail, the epitaxial region 26 extends from the first front surface 3A of the die 3, deep in the die 3 along the third axis Z, up to the first epitaxial region 25.

The second epitaxial region 26 may have a type of doping that is the same as or different from that of the substrate 15, in particular here the same (P), according to the specific application.

The second epitaxial region 26 may have a doping level that is uniform or variable along the first axis, the second axis, and/or the third axis Z, for example so as to have a resistivity comprised between 0.02 Ω·cm and 20 Ω·cm, for instance with a doping level comprised between 8·10¹⁴ atoms/cm³ and 5·10¹⁹ atoms/cm³.

The third epitaxial region 27 extends in the die 3 underneath the epitaxial multilayer 21, facing the latter parallel to the third axis Z.

The third epitaxial region 27 may be a region buried in the die 3.

In detail, the third epitaxial region 27 extends within the second epitaxial region 26, at a distance from the first epitaxial region 25.

The third epitaxial region 27 may be of P or N type (of N type in the embodiment of Figure 1) and may have a doping level that is uniform or variable along the first axis, the second axis, and/or the third axis Z, for example so as to have a resistivity comprised between 0.02 Ω·cm and 20 Ω·cm, for instance with a doping level comprised between 8·10¹⁴ atoms/cm³ and 5·10¹⁹ atoms/cm³. The presence both of the first and the third epitaxial regions 25, 27 of N type (i.e., of a type different from that of the substrate 15) may be useful for simplifying manufacturing of the device 1 and for obtaining, in use, excellent electrical performance of the device 1, in the case where the first HEMT 5A is designed for operating at high voltages with respect to the substrate 15, for example starting from approximately 20 V, e.g., 60 V, 100 V, or 650 V.

The fourth epitaxial region 28 extends on the third epitaxial region 27 and has a central portion 28A and a peripheral portion 28B that surrounds the central portion 28A.

In this embodiment, the epitaxial multilayer 21 is grown starting from the fourth epitaxial region 28, in particular from the respective central portion 28A.

In the embodiment of Figure 1, the peripheral portion 28B is contiguous with the central portion 28A.

Furthermore, in the embodiment of Figure 1, the peripheral portion 28B is in contact with the second epitaxial region 26. In detail, in this embodiment, the peripheral portion 28B of the fourth epitaxial region 28 is laterally contiguous, parallel to the first axis X, to the second epitaxial region 26.

The fourth epitaxial region 28 may be of N or P type (here of N type) and may have a doping level that is uniform or variable, for example so as to have a resistivity comprised between 0.02 Ω·cm and 20 Ω·cm, for instance with a doping level comprised between 8·10¹⁴ atoms/cm³ and 5·10¹⁹ atoms/cm³.

In particular, the fourth epitaxial region 28 may have a peak doping level lower than that of the third epitaxial region 27. This may be useful during manufacturing for optimizing the growth of the epitaxial multilayer 21.

The fifth epitaxial region 29 extends on the fourth epitaxial region 28, in particular within the second epitaxial region 26.

In detail, the fifth epitaxial region 29 extends on the peripheral portion 28B of the fourth epitaxial region 28, in particular overlying it.

The fifth epitaxial region 29 may be of P or N type (here of N type) and have a doping level that is uniform or variable, for example so as to have a resistivity comprised between 0.1 Ω·cm and 20 Ω·cm.

The epitaxial multilayer 21 extends on the central portion 28A of the fourth epitaxial region 28, in particular in direct contact therewith, up to a top surface 30. The top surface 30 forms a second front surface of the active area 7A.

In practice, the epitaxial multilayer 21 is grown starting from the fourth epitaxial region 28.

Overall, the thickness along the third axis Z of the body structure 20 underneath the epitaxial multilayer 21, i.e., measured between the bottom surface of the epitaxial multilayer 21 and the top surface 15A of the substrate 15, may be comprised between 5 µm and 30 pm, for example approximately 15 µm, according to the specific application.

The first HEMT 5A is integrated in the heterostructure 22 of the epitaxial multilayer 21.

In the embodiment of Figure 2, the epitaxial multilayer 21 also comprises a transition region 32, which is formed by one or more buffer layers (here not illustrated) overlying one another and is arranged between the fourth epitaxial region 28 and the heterostructure 22. The transition region 32 may be useful during manufacturing of the device 1 to favour epitaxial growth of the heterostructure 22 on the fourth epitaxial region 28.

For instance, the transition region 32 may be formed by a layer of aluminium nitride (AlN), which extends on, and in direct contact with, the fourth epitaxial region 28, and a layer of aluminium and gallium nitride (AlGaN), which extends on, and in direct contact with, the AlN layer.

The heterostructure 22 comprises compound semiconductor materials including elements of Groups III and V of the Periodic Table.

In this embodiment, the heterostructure 22 forms the top surface 30 of the epitaxial multilayer 21.

The top surface 30 of the epitaxial multilayer 21 may extend at a coordinate along the third axis Z that is the same as or different from that of the first front surface 3A of the die 3, according to the specific manufacturing steps used for producing the device 1.

In particular, in this embodiment, the top surface 30 of the epitaxial multilayer 21 extends at a smaller distance, measured along the third axis Z, from the substrate 15 than the first front surface 3A of the die 3. This may enable improving manufacturing of the device 1.

The heterostructure 22 comprises a channel layer 35 and a barrier layer 36 overlying one another.

The channel layer 35 is of a first semiconductor material, for example gallium nitride (GaN) or an alloy comprising gallium nitride, such as InGaN, here gallium nitride (GaN), and extends on the transition region 32, in particular in direct contact therewith.

The barrier layer 36 is of a second semiconductor material, for example a compound based upon a ternary or quaternary alloy of gallium nitride, such as AlₓGa₁₋ₓN, AlInGaN, InₓGa₁₋ₓN, AlₓIn₁₋ₓAl, AlScN, here aluminium and gallium nitride (AlGaN), and extends on the channel layer 35, in particular in direct contact therewith, up to the top surface 30 of the epitaxial multilayer 21.

The channel layer 35 and the barrier layer 36 may be of intrinsic, P or N type, according to the specific application; in particular, both the channel layer 35 and the barrier layer 36 may be of N type.

For instance, when the barrier layer 36 is of AlGaN, the presence of aluminium atoms may cause the barrier layer 36 to be of N type.

The heterostructure 22 is configured to house a two-dimensional gas of (mobile) charge carriers, in particular here electrons (2DEG), which is arranged between the channel layer 35 and the barrier layer 36, in particular at the interface between the channel layer 35 and the barrier layer 36.

Insulating regions may extend on the top surfaces 3A, 30, for example with the function of passivation, electrical insulation, etc., in a way in itself known and according to the specific application.

The first HEMT 5A further comprises surface structures, for example various conductive and/or insulating regions that may vary according to the specific type of the first HEMT 5A, which extend on the top surface 30 of the epitaxial multilayer 21 and form functional regions of the first HEMT 5A.

In this embodiment, the first HEMT 5A comprises a source region 40 and a drain region 41, of conductive material, extending at a distance from one another along the first axis X.

The source region 40 may form, in top plan view, a closed line having a generically ring shape, two portions of which are illustrated in the cross-section of Figure 2. For instance, the source region 40 may have a shape that is circular, polygonal, regular, or irregular, according to the specific design layout.

The drain region 41 may, for example, have, in top plan view, a strip-like shape elongated along the second axis Y or a different shape, for example circular, polygonal, regular, or irregular.

The source region 40 and the drain region 41 are in electrical contact, in particular ohmic contact, with the heterostructure 22, in particular with the two-dimensional gas forming at the interface between the channel layer 35 and the barrier layer 36, and form, respectively, a source terminal S and a drain terminal D of the first HEMT 5A.

In the embodiment of Figure 2, the source and drain regions 40, 41 extend, in a direction parallel to the third axis Z, up to the top surface 30.

However, the source and drain regions 40, 41 may extend, parallel to the third axis Z, partially also through the heterostructure 22, for example through part of the barrier layer 36 or throughout the thickness of the barrier layer 36, in particular up to the interface with the channel layer 35, according to the specific application.

The surface structures of the first HEMT 5A also comprise a gate structure, here formed by a channel-modulation region 43 and a gate-contact region 44, which may be biased to control electrically formation of the two-dimensional gas in the heterostructure 22 between the source region 40 and the drain region 41.

The gate structure 43, 44 extends between the source region 40 and the drain region 41. The gate structure 43, 44 may form, in top plan view, a closed line having a generically ring shape, two portions of which are illustrated in the cross-section of Figure 2. For instance, the gate structure 43, 44 may have a shape that is circular, polygonal, regular, or irregular, according to the specific design layout.

In practice, the gate structure 43, 44 may be arranged internally with respect to the source region 40, for example in a substantially concentric way with respect to the source region 40.

The gate structure 43, 44 forms a gate terminal G of the first HEMT 5A.

In this embodiment, the first HEMT 5A is of a normally off type, i.e., of the enrichment type.

In detail, in this embodiment, the channel-modulation region 43 is of semiconductor material and has a conductivity of a type different from that of the barrier layer 36, for example, of a P type. In particular, the channel-modulation region 43 may be made of gallium nitride of a P type (p-GaN).

However, the channel-modulation region 43 may be formed by an ensemble of different materials that include dielectric layers, metal layers, and/or semiconductor layers used as control electrodes with appropriate work function.

The channel-modulation region 43 extends on the top surface 30, between the source region 40 and the drain region 41, along the first axis X.

The gate-contact region 44, of conductive material, extends in electrical contact with the channel-modulation region 43, in particular here in direct contact therewith.

The device 1 further comprises a separation region 50 that extends in the die 3 within the active area 7A.

In detail, the separation region 50 extends on the fourth epitaxial region 28, in particular in direct contact therewith, and surrounds the epitaxial multilayer 21.

In the embodiment of Figure 2, the separation region 50 extends, parallel to the first axis X, between the epitaxial multilayer 21 and the fifth epitaxial region 29.

In detail, the separation region 50 comprises: a definition region 52, for example including an oxide, in particular silicon oxide, which extends on, and in direct contact with, the fourth epitaxial region 28; and a polycrystalline region 53, of the same material (silicon) as the fifth epitaxial region 29, which extends on, and in direct contact with, the definition region 52.

The definition region 52 may be formed by a single layer, for example an oxide layer, in particular a silicon-oxide layer, or else by a multilayer comprising, for instance, one or more layers of an oxide and/or one or more layers of a nitride.

In detail, according to one embodiment, the definition region 52 may be of silicon oxide.

According to a different embodiment, the definition region 52 may comprise an oxide layer, in particular a silicon-oxide layer, and a nitride layer. According to one embodiment, the oxide layer may be in direct contact with the semiconductor layer 18.

The presence of oxide, in particular silicon oxide, allows to simplify manufacturing of the heterostructure 22 of the first transistor 5A.

The definition region 52 may have a thickness along the third axis Z comprised, for example, between 7 nm and 300 nm, in particular between 70 Å and 200 Å.

In this embodiment, the polycrystalline region 53 has a polycrystalline structure.

In this embodiment, the polycrystalline region 53 is monolithic with the fifth epitaxial region 29.

The polycrystalline region 53 has an outer side wall 55 that separates the polycrystalline region 53 from the fifth epitaxial region 29. The outer side wall 55 has an inclination that may depend upon the crystal orientation of the fifth epitaxial region 29 and upon the thickness along the third axis Z of the definition region 52. For instance, in the case where the fifth epitaxial region 29 is oriented according to the crystallographic direction <111>, the outer side wall 55 may form an angle of approximately 54° with a direction parallel to the first axis X.

The polycrystalline region 53 also has an inner side wall 56, opposite to the outer side wall 55, which faces the epitaxial multilayer 21.

The epitaxial multilayer 21 has a peripheral portion, arranged outside the source region 40, which extends in contact with the inner side wall 56 of the separation region 50.

The shape of said peripheral portion, here not described in detail and illustrated only schematically in Figure 2, depends upon the specific manufacturing steps used for forming the device 1.

For instance, the epitaxial multilayer 21 may grow conformably also on the inner side wall 56.

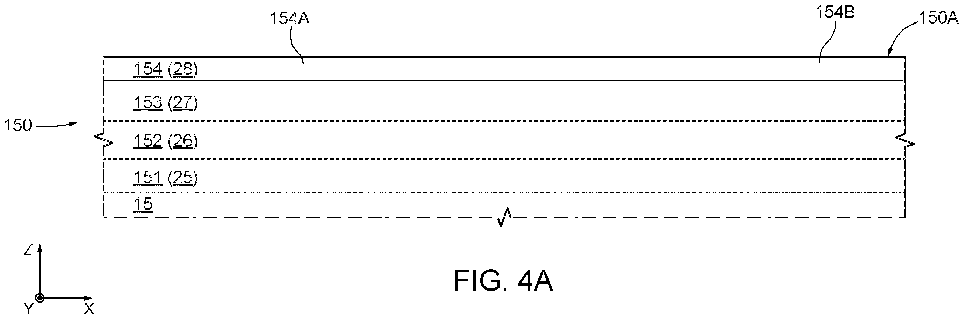

The separation region 50 may be useful, during manufacture, to favour a good crystallographic quality of the epitaxial multilayer 21, as described in detail hereinafter with reference to Figures 4A-4H.

Furthermore, the presence of the polycrystalline region 53 may be useful for reducing the stress caused by the lattice mismatch between the materials that form the epitaxial multilayer 21 (e.g., GaN) and the material that forms the body structure 20 (e.g., silicon). Consequently, the presence of the polycrystalline region 53 may contribute to the reduction of the risk of dislocations in the die 3 (and thus possible breaking of the device 1).

The shape and structure of the separation region 50 may vary with respect to what has been illustrated and described with reference to Figure 2, according to the specific manufacturing steps used for producing the device 1. For instance, the separation region 50 may even be absent.

The device 1 may further comprise one or more insulating or conductive regions, at the first front surface 3A, according to the specific application and the specific layout of the active area 7A. For instance, Figure 2 shows an insulating region 58, for example of silicon oxide, which extends from the surface 3A into the body structure 20, around the epitaxial multilayer 21.

In detail, the insulating region 58 is in contact with (contiguous to) the epitaxial multilayer 21.

With reference to the embodiment illustrated in Figure 2, the insulating region 58 is contiguous with the interface between the channel layer 35 and the barrier layer 36. This may be useful for insulating electrically the 2DEG from the body structure 20.

The insulation structure 8 of the first HEMT 5A extends in the die 3 around the body structure 20 of the first HEMT 5A; in particular, it is contiguous to (in contact with) the body structure 20.

In detail, the insulation structure 8 extends in the die 3 from the first front surface 3A up to the substrate 15, in contact therewith.

In practice, the insulation structure 8 laterally delimits, within the die 3, the body structure 20.

In the embodiment of Figure 2, the insulation structure 8 is a junction insulation structure configured to form a PN junction alongside, in particular around, the body structure 20. However, the insulation structure 8 may be of a different type, for example a deep-trench insulation (DTI) structure.

In detail, the insulation structure 8 comprises a first junction region 60 of semiconductor material (here silicon) of N type, and a second junction region 61 of semiconductor material (here silicon) of P type, which are adjacent to one another.

In particular, in the embodiment of Figure 2, the first and second junction regions 60, 61 are in contact with one another.

The first and second junction regions 60, 61 may be formed by growing one or more epitaxial layers on the substrate 15 and subsequent implantation or diffusion of dopant species, in a way in itself known.

The first junction region 60 extends, in a direction parallel to the third axis Z, between the substrate 15 and the first front surface 3A of the die 3.

In detail, the first junction region 60 is in contact with the substrate 15; in particular, it extends from the top surface 15A of the substrate 15 up to the first front surface 3A.

The first junction region 60 extends, in a direction parallel to the first axis X, adjacent to the body structure 20, in particular contiguous to (in contact with) the first and the second epitaxial regions 25, 26. The fact that the first junction region 60 is in contact with the first epitaxial region 25 allows to use the first junction region 60 to bias, in use, the first epitaxial region 25.

The first junction region 60 has the same conductivity type as the first epitaxial region 25.

The first junction region 60 may have, parallel to the third axis Z, a doping level that is uniform or variable, according to the specific application. The first junction region 60 may, for example, have a doping level comprised between 1·10¹⁵ atoms/cm³ and 5·10¹⁸ atoms/cm³.

The second junction region 61 extends, parallel to the third axis Z, between the substrate 15 and the first front surface 3A of the die 3.

In detail, the second junction region 61 is in contact with the substrate 15; in particular, it extends from the top surface 15A of the substrate 15 up to the first front surface 3A.

The fact that the second junction region 61 is in contact with the substrate 15 allows to use the second junction region 61 to bias, in use, the substrate 15.

The second junction region 61 has the same conductivity type as the substrate 15.

The second junction region 61 may have, parallel to the third axis Z, a doping level that is uniform or variable, according to the specific application. The second junction region 61 may, for example, have a doping level comprised between 1·10¹⁵ atoms/cm³ and 5·10¹⁸ atoms/cm³.

What has been described with reference to the first HEMT 5A applies, *mutatis mutandis,* also to the second HEMT 5B integrated in the active area 7B. In particular, in the embodiment of Figure 2, the second HEMT 5B has a structure that is the same as that of the first HEMT 5A. Consequently, the elements of the second HEMT 5B that are the same as those of the first HEMT 5A are designated by the same reference number, increased by 50, and are not described in detail any further.

In practice, the second HEMT 5B comprises a body structure 70 and an epitaxial multilayer 71.

Also in the second HEMT 5B, the body structure 70 comprises a doped region having a conductivity type different from that of the substrate 15.

In detail, the body structure 70 comprises a first epitaxial region 75, a second epitaxial region 76, a third epitaxial region 77, a fourth epitaxial region 78 (with a respective central portion 78A and a respective peripheral portion 78B), and a fifth epitaxial region 79.

However, the size, shape, type of doping, and doping level of the epitaxial regions 75-79 of the second HEMT 5A may be the same as or different from the epitaxial regions 25-29 of the first HEMT 5A, according to the specific application.

The epitaxial multilayer 71 comprises a heterostructure 72 housing a two-dimensional gas of charge carriers, in particular electrons, on which operation of the second HEMT 5B is based, i.e., which forms the conductive channel of the second HEMT 5B.

The heterostructure 72 comprises a channel layer 85 and a barrier layer 86.

The epitaxial multilayer 71 also comprises a transition region 82.

Shape, size, number of layers, and materials of the epitaxial multilayer 71 of the second HEMT 5B may be the same as or different from those of the epitaxial multilayer 21 of the second HEMT 5A, according to the specific application.

The second HEMT 5B further comprises also a source region 90, a drain region 91, and a gate structure, formed by a channel-modulation region 93 and a gate-contact region 94.

The device 1 further comprises a separation region 100 that extends in the die 3 within the active area 7B and comprises a definition region 102 and a polycrystalline region 103. The polycrystalline region 103 has an outer side wall 105 and an inner side wall 106.

The device may also comprise conductive and/or insulating regions that extend in the active area 7B, of which only one insulating region 108 is illustrated by way of example in Figure 2.

What has been described for the insulation structure 8 of the first HEMT 5A also applies *mutatis mutandis* to the insulation structure 9 of the second HEMT 5B. In detail, also the insulation structure 9 is of the junction type and comprises a first junction region 110 and a second insulation region 111.

In the embodiment of Figure 2, the second junction region 111 forms, on the side facing the first transistor 5A, a single region with the second junction region 61. The second junction regions 61, 111 are thus separated, for reasons of clarity, by a dashed line in Figure 2.

In practice, with reference to the first HEMT 5A, the first epitaxial region 25 and the third epitaxial region 27 are buried regions of the body structure 20 that extend between the heterostructure 22 and the substrate 15, parallel to the third axis Z.

The fact that the first epitaxial region 25 has a conductivity type different from that of the substrate 15 causes a PN junction to be formed at the top surface 15A of the substrate 15.

Consequently, in use, by appropriately biasing the first epitaxial region 25 and the substrate 15, it is possible to insulate electrically the heterostructure 22 from the substrate 15.

In other words, in use, it is possible to prevent the substrate 15 from working as undesired conductive channel between the heterostructure 22 and further electronic components integrated in the die 3 (e.g., the second HEMT 5B or the electronic components based upon a single semiconductor material 10).

In practice, in use, it is possible to prevent the electrical performance of the first HEMT 5A from depending upon the biasing voltage of the substrate 15.

Furthermore, the presence of the insulation structure 8 may enable the first HEMT 5A to be electrically insulated also laterally (parallel to the first and second axes X, Y) from the other electronic components integrated in the die 3. In practice, the insulation structure 8 contributes to increasing the electrical insulation of the body structure 20 of the first HEMT 5A from the adjacent devices.

Consequently, it is possible to prevent the electrical performance of the first HEMT 5A from depending, in use, upon the operating voltages applied to the other electronic components integrated in the die 3, outside the active area 7A.

At the same time, the fact that both the substrate 15 and the body structure 20 are of semiconductor material, here monocrystalline silicon, in particular with <111> orientation, allows to obtain a good crystallographic quality of the heterostructure 22.

What has been described with reference to the electrical insulation of the body structure 20 of the first HEMT 5A also applies to that of the body structure 70 of the second HEMT 5B.

Consequently, the body structures 20, 70 of the first and second HEMTs 5A, 5B may be biased, in use, independently of one another.

In practice, in the device 1, a plurality of electronic components based on heterostructure may be integrated in a same die, while at the same time guaranteeing the electrical decoupling of the respective body structures, with consequent advantages in terms of occupation of area, electrical performance and design versatility as compared to a solution in which the electronic components are integrated in dice that are distinct from one another.

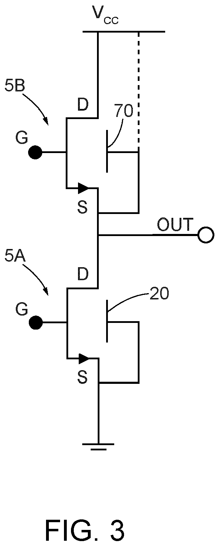

For instance, according to one embodiment, the device 1 may comprise conductive regions, represented only schematically in Figure 2, so as to couple electrically the first and second HEMTs 5A, 5B in a the source-follower configuration (as illustrated in the electrical equivalent of Figure 3).

In Figures 2 and 3, the first HEMT 5A is a low-side switch, the source terminal S of which is coupled to ground, and the second HEMT 5B is a high-side switch, the drain terminal D of which is coupled to an operating voltage V_{cc} (e.g., approximately 48 V). The source terminal S of the second HEMT 5B and the drain terminal D of the first HEMT 5A are coupled together and form an output terminal OUT of the source-follower circuit.

As discussed above, the body structures 20, 70 of the first and second HEMTs 5A, 5B may be electrically decoupled from one another and thus biased independently.

In the example illustrated, both the body structure 20 of the first HEMT 5A and the body structure 70 of the second HEMT 5B are electrically connected to the respective source region 40, 90.

The substrate 15 may be connected to ground.

The possibility of keeping the body structures 20, 70 decoupled from one another allows to maintain the biasing voltage of the body structures 20, 70 stable. Consequently, both the first and second HEMTs 5A, 5B may have a stable value of ON-state resistance, which is not affected by the potential difference applied between the high-voltage connected terminal of the component and the substrate potential. Consequently, the device 1 may have a high reliability, in use, even when the first and second HEMTs 5A, 5B are used in a configuration of the source-follower type.

Described hereinafter with reference to Figures 4A-4H is a sequence of manufacturing steps that may be used for producing the semiconductor electronic device 1.

In detail, Figures 4A-4H show, for simplicity and without this implying any loss of generality, only the manufacturing steps regarding a portion of the active area 7A in which the first HEMT 5A is integrated.

Figure 4A is a cross-section of a wafer 150 of monocrystalline semiconductor material, in particular silicon, having a top surface 150A.

The wafer 150 comprises the substrate 15, on which four epitaxial layers 151, 152, 153, 154 have already been grown, which are intended to form, at least in part, the first epitaxial region 25, the second epitaxial region 26, the third epitaxial region 27 and, respectively, the fourth epitaxial region 28 (indicated for simplicity in brackets in Figure 4A).

The fourth epitaxial layer 154 forms the top surface 150A of the wafer 150.

The fourth epitaxial layer 154 comprises a first portion 154A, which is intended to form the peripheral portion 28B of the fourth epitaxial region 28, and a second portion 154B, which is intended to form the central portion 28A of the fourth epitaxial region 28.

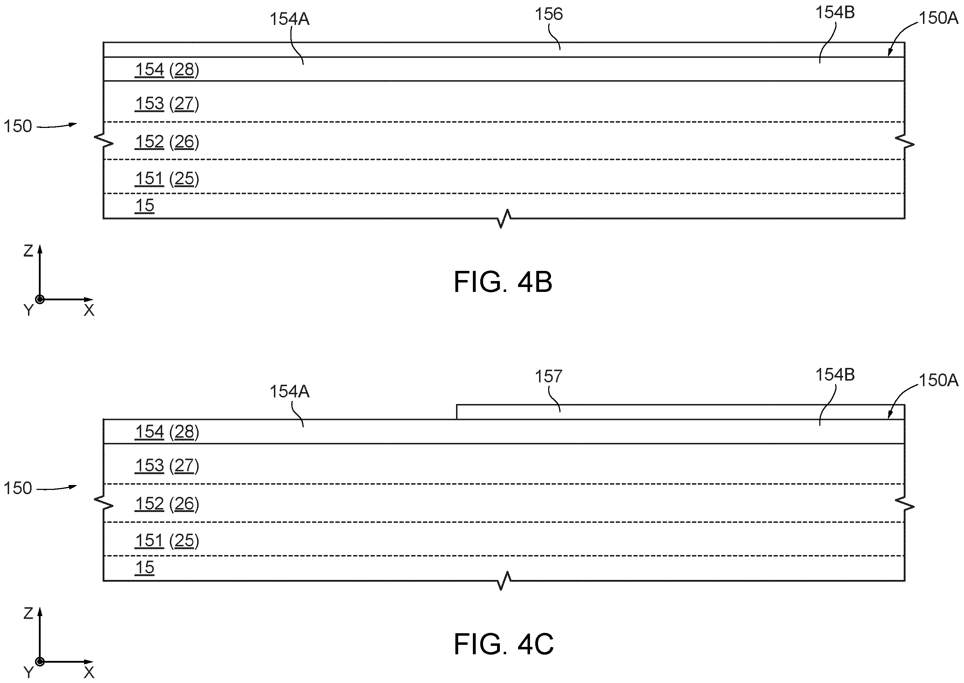

Next (Figure 4B), a definition layer 156, for example an oxide layer, in particular of silicon oxide, is formed on the top surface 150A.

The definition layer 156 may have a small thickness along the third axis Z comprised, for example, between 7 nm and 300 nm, in particular between 70 Å and 200 Å.

The definition layer 156 is intended to form the definition region 52 (Figure 2).

The definition layer 156 may be formed via oxidation of a surface portion of the fourth epitaxial layer 154, or else via deposition on the top surface 150A. In the case of oxidation, the thickness of the fourth epitaxial layer 154 may be reduced, following upon oxidation, as compared to that of the layer 18 represented in Figure 3A. However, given the much smaller thickness of the definition layer 156 as compared to the thickness of the fourth epitaxial layer 154, it may be assumed for simplicity that the thickness of the fourth epitaxial layer 154 will remain, to a first approximation, the same before and after oxidation.

Then (Figure 4C), the definition layer 156 is removed at the first portion 154A of the fourth epitaxial layer 154 (where the fifth epitaxial region 29 of Figure 2 is to be formed). Of the definition layer 156 there thus remains a portion also referred to hereinafter as the growth mask 157.

In practice, the growth mask 157 exposes the first portion 154A of the fourth epitaxial layer 154 and cover the second portion 154B of the fourth epitaxial layer 154.

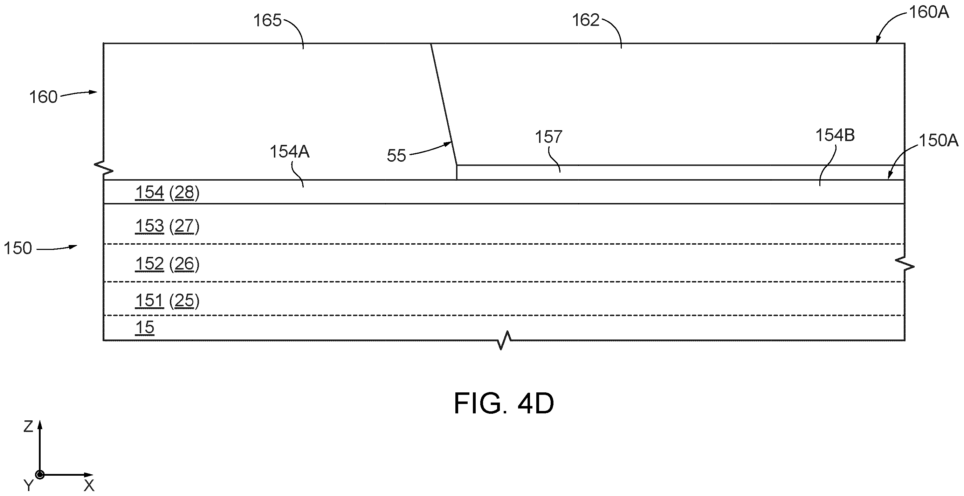

In Figure 4D, a surface layer 160 of semiconductor material, in particular the same material as that of the fourth epitaxial layer 154 (here silicon), is grown on the wafer 150.

The surface layer 160 has a top surface 160A (which is intended to form the first front surface 3A of Figure 2).

The surface layer 160 comprises an epitaxial portion 161 that grows parallel to the third axis Z from the fourth epitaxial layer 154 and a sacrificial portion 162 that grows parallel to the third axis Z on the growth mask 157.

The epitaxial portion 161, which grows from a monocrystalline substrate, maintains the monocrystalline structure of the fourth epitaxial layer 154 and is intended to form the fifth epitaxial region 29 (Figure 2).

The sacrificial portion 162, which grows from a non-crystalline substrate, has a polycrystalline structure.

In the wafer 150, now comprising also the surface layer 160, there may further be formed, in a way not illustrated herein and in itself known, the insulation structure 8 of Figure 2.

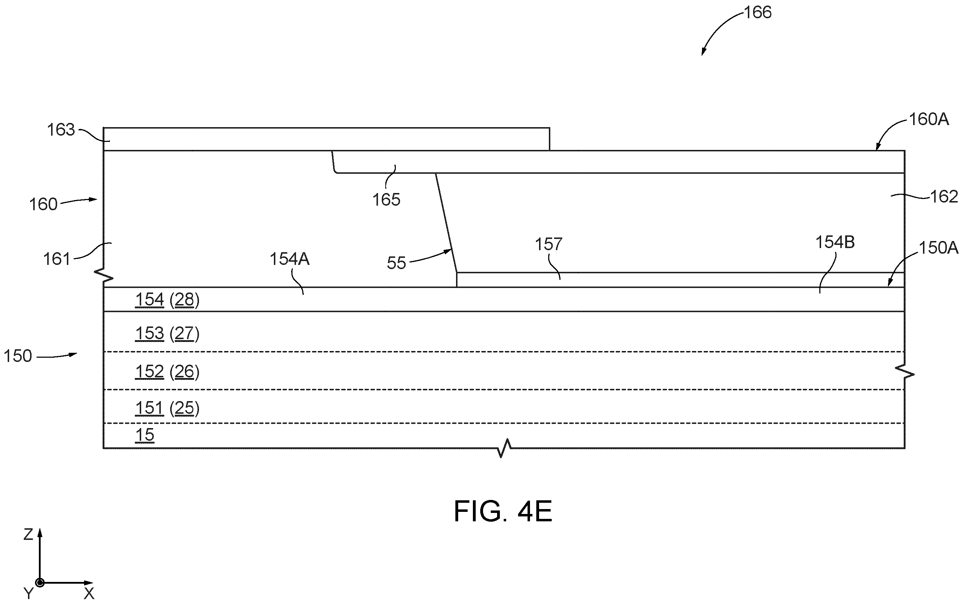

In Figure 4E, an etch mask 163 is formed on the surface layer 160. The etch mask 163 may be formed by one or more layers.

The etch mask 163 forms an opening 166 that exposes, at least in part, the sacrificial portion 162.

Furthermore, an insulating layer 165 may be formed in the surface layer 160, prior to formation of the etch mask 163, for example via formation of insulation trenches, for example shallow-trench insulation (STI). The insulating layer 165 may be intended to form the insulating region 58 of Figure 2.

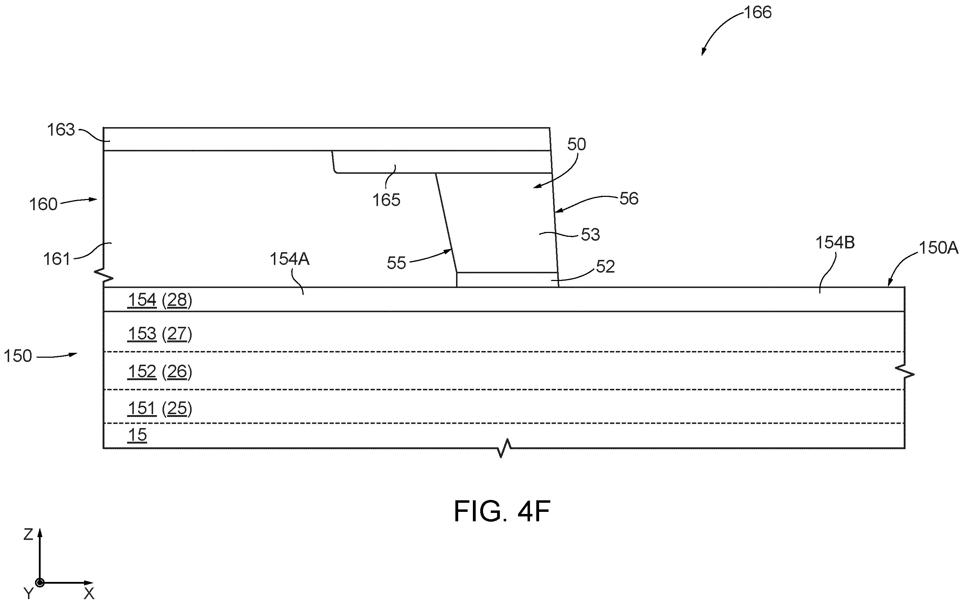

Next (Figure 4F), the insulating layer 165, the sacrificial portion 162, and the growth mask 157 are removed at the opening 166, using the etch mask 163.

Of the sacrificial portion 162 there thus remains the portion arranged underneath the etch mask 163, which will form the polycrystalline region 53 of Figure 2 and is still designated by 53.

Of the growth mask 157 there thus remains the portion arranged underneath the polycrystalline region 53, corresponding to the definition region 52 of Figure 2 and thus designated by the same reference number.

In practice, following upon the etching of Figure 4F, the recess that has formed in the sacrificial portion 162 and in the growth mask 157 exposes part of the underlying portion 154B of the fourth epitaxial layer 154.

Etching of the growth mask 157 and of the sacrificial portion 162 may be performed using two different etch chemistries. Consequently, the growth mask 157 may be etched using a selective chemistry that does not etch, to a first approximation, the fourth epitaxial layer 154. Consequently, the fourth epitaxial layer may maintain a good surface crystallographic quality.

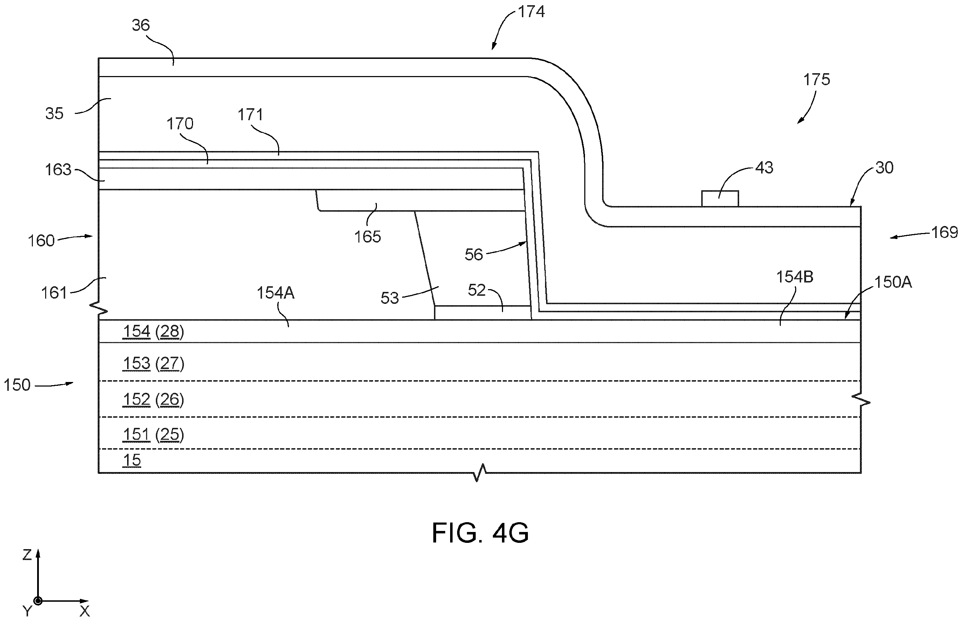

Then (Figure 4G), a work multilayer 169, which is intended to form the epitaxial multilayer 21 of Figure 2, is grown on the wafer 150.

In detail, the work multilayer 169 comprises a first buffer layer 170, for example of AlN, which extends directly on the exposed portion of the second portion 154B of the fourth epitaxial layer 154; and a second buffer layer 171, for example of AlGaN, which grows on the first buffer layer 170.

The first and second buffer layers 170, 171 will form the transition region 32 of the epitaxial multilayer 21 (Figure 2).

The channel layer 35 and the barrier layer 36 are further grown on the second buffer layer 171.

In the embodiment illustrated, the work multilayer 169 grows conformably also on the inner side wall 56 of the polycrystalline region 53 and on the etch mask 163.

In practice, the work multilayer 169 comprises a raised portion 174, which extends on the etch mask 163 and on the inner side wall 56, and a useful portion 175 that extends directly on the fourth epitaxial layer 154.

The useful portion 175 has a top surface that is substantially planar, in particular substantially parallel to the surface 150A of the wafer 150, and will form the second front surface 30 (Figure 2) and is thus designated by the same reference number.

Still with reference to Figure 4G, the channel-modulation region 43 is formed, in a way in itself known, for example via growth and definition of a specific layer, on the top surface 30 of the useful portion 175.

In practice, in this embodiment, the useful portion 175 of the work multilayer 169 also comprises the channel-modulation region 43.

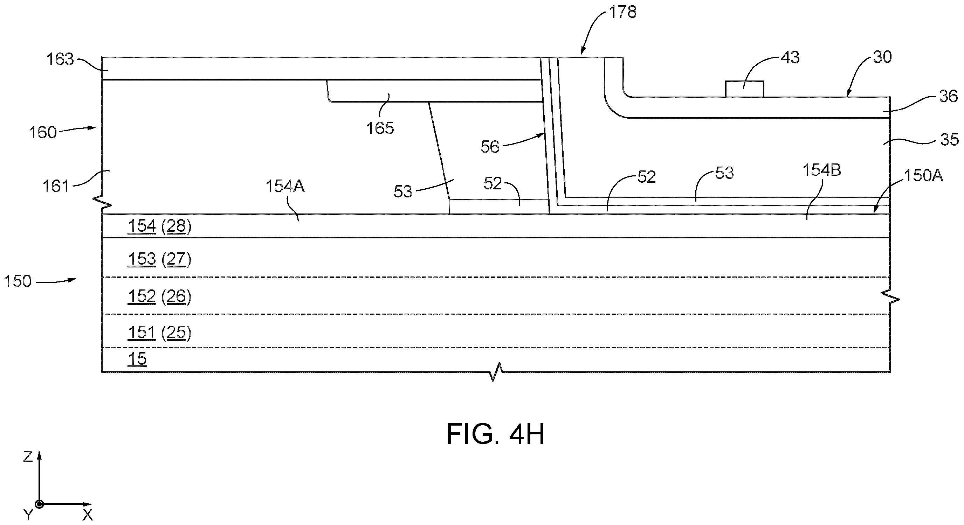

Next (Figure 4H), the raised portion 174 of the work multilayer 169 is removed above the etch mask 163, for example via planarization, for instance chemical-mechanical polishing (CMP) or other etching techniques.

One or more insulating layers (here not illustrated) may be formed on the top surface 30 to protect the channel-modulation region 43.

In the embodiment illustrated, following upon removal of the raised portion 174, there remains only the part extending on the inner side wall 56, which will form a peripheral portion 178 of the epitaxial multilayer 21.

However, as described with reference to Figure 2, the shape of the peripheral portion 178 of the epitaxial multilayer 21 may be different from the one illustrated. For instance, further etching steps may be carried out to remove, at least in part, the peripheral portion 178.

Next, in a way not illustrated herein, the etch mask 163 is removed, at least in part.

Moreover, further manufacturing steps follow, in themselves known and not illustrated, for forming the surface structures of the first HEMT 5A (metal contact regions and passivation and insulation regions).

Final manufacturing steps (here not illustrated) also follow, such as formation of top layers of metal interconnection and dicing of the wafer 150, which lead to formation of the device 1.

It will be clear to the person skilled in the art that what has been described with reference to Figures 4A-4H may be applied also for manufacturing the second HEMT 5B.

It will further be clear to the person skilled in the art that the silicon electronic components 10 may be formed in the wafer 150 in specific epitaxial layers grown on the substrate 15.

The possibility of using the <111> silicon substrate 15 as starting substrate for forming the semiconductor electronic device 1 may allow to obtain a high epitaxial quality of the heterostructure 22, in particular when the channel layer 35 is made of GaN. Consequently, the electronic components based on heterostructure 5 may have excellent electrical performance. The applicant has also found that the use of the <111> silicon substrate 15 also allows to obtain excellent electrical performance of any silicon-based electronic components 10 integrated in the die 3.

Finally, it is clear that other modifications and variations may be made to the electronic device 1 and to the corresponding manufacturing process described and illustrated herein, without thereby departing from the scope of the present invention, as defined in the annexed claims.

The device 1 may also comprise other silicon-based electronic components 10 integrated in the die 3, in addition to or instead of those illustrated in Figure 1. For instance, the components 10 may include MOS transistors for applications at low voltage, for example lower than 15 V, or at medium voltages, for example from 15 V to 20 V; DMOS transistors and/or drift MOS transistors, for example for applications at operating voltages of from 20 V to 200 V; thin-film resistors; OTP or MTP memories; phase-change memories; etc.

For instance, the conductivity type, N or P, of the various semiconductive regions may be reversed as compared to what has been described.

For instance, the substrate 15 may be formed by a substrate with a resistivity comprised between 0.002 Ω·cm and 0.1 Ω·cm, on which an epitaxial layer has been grown having a thickness comprised, for example, between 1 µm and 40 µm and having a resistivity comprised, for example, between 0.1 Ω·cm and 20 Ω·cm.

For instance, the epitaxial multilayer 21, 71 may not comprise the respective transition region 32, 82. In other words, the heterostructure 21, 71 may be grown directly on the respective body structure 20, 70. In addition or as an alternative, the heterostructure 22, 72 may comprise further layers, for example of semiconductor or insulating material, according to the specific application and the specific manufacturing steps used for growth.

For instance, the device 1 may comprise components based on heterostructure other than HEMTs.

For instance, the first HEMT 5A and/or the second HEMT 5B may be of a normally off type, and wherein the gate structure may be different from what has been described previously; for example, the gate structure may be of a recessed type, and/or manufacture of the gate structure may include the use of fluorine plasma underneath the gate structure. Alternatively, the first HEMT 5A and/or the second HEMT 5B may be of a normally on type, i.e., of the depletion type.

For instance, the number of epitaxial regions that form the body structure 20 and/or 70 may be different, according to the specific application.

For instance, with reference to the first (or second) HEMT 5A (or 5B), the fourth epitaxial region 28 (or 78) may be absent, and the epitaxial multilayer 21 (or 71) may be grown directly on the third epitaxial region 27 (or 77). This may favour reduction of the manufacturing costs.

In the case of medium-voltage or low-voltage applications (e.g., up to approximately 20 V) the body structure 20 and/or 70 may comprise only the respective first epitaxial region 25, 75. In practice, in this case, the epitaxial multilayer 21 and/or 71 may be grown directly on the respective first epitaxial region 25, 75.

For instance, one or more silicon-based electronic components 10 may be integrated within the active area 7A and/or 7B, according to the specific application. In this case, the silicon-based electronic components 10 may be integrated in an epitaxial region contiguous with the fifth epitaxial region 29. For instance, with reference to Figure 4D, one or more silicon-based electronic components 10 may be integrated in the epitaxial portion 161 of the surface layer 160.

For instance, the electronic components 10 may be electronic components based upon a single semiconductor material other than silicon, for example Ge, SiGe, etc.

For instance, with reference to the use of the first and second HEMTs 5A, 5B in a source-follower configuration, the body structure 70 of the second HEMT 5B may be coupled to the operating voltage V_{cc} and not to the respective source region 90 (as indicated by a dashed line in Figure 3).

For instance, still with reference to Figure 3, the first HEMT 5A may be used as high-side switch, and the second HEMT 5B may be used as low-side switch.

For instance, according to one embodiment, the first junction region 60 and the first epitaxial region 25 may be electrically connected to the drain terminal D of the first HEMT 5A, and not to the source terminal S of the first HEMT 5A; and/or the first junction region 110 and the first epitaxial region 75 may be electrically connected to the drain terminal D of the second transistor 5B, and not to the source terminal S of the second transistor 5B. In this way, in use, it is possible to bias the regions 75 and 110 at an arbitrary potential different from, in particular higher, than the potential applied to the region 25.

For instance, the manufacturing steps described with reference to Figures 4A-4H and the respective order of execution may be different from what has been illustrated and discussed, according to the specific processes and machinery used.

For instance, growth of the epitaxial multilayer 21, 71 may be different from what has been described with reference to Figure 4G, according to the specific growth parameters used. As described with reference to Figures 2 and 4G, the shape of the peripheral portion of the epitaxial multilayer 21, 71 may be different from the one illustrated.

For instance, the multilayer 169 may grow selectively only starting from the exposed portion 154B of the fourth epitaxial layer 154. In this case, the raised portion 174 would not be present; consequently, the removal represented in Figure 4H may be absent.

For instance, the embodiments described may be combined together to provide further solutions.

## Claims

1. A semiconductor electronic device (1) comprising:
a die (3) comprising a substrate (15) of semiconductor material having a first conductivity type (P); and
a first electronic component (5A, 5B) based on heterostructure, comprising a body structure (20, 70) of semiconductor material extending, in the die, on the substrate (15), and an epitaxial multilayer (21, 71) extending in contact with the body structure and comprising a heterostructure (22, 72),
wherein the body structure of the first electronic component comprises a first doped region (25, 27, 75, 77) of semiconductor material extending between the heterostructure and the substrate and having a second conductivity type (N) different from the first conductivity type.

2. The electronic device according to the preceding claim, wherein the first doped region (25, 27, 75, 77) extends in contact with the substrate.

3. The electronic device according to any one of the preceding claims, wherein the body structure (20, 70) also comprises a second doped region (27, 77) having the second conductivity type (N) and extending between the heterostructure and the substrate (15), at a distance from the first doped region (25, 75).

4. The electronic device according to any one of the preceding claims, wherein the body structure (20, 70) comprises a third doped region (28, 78) having the second conductivity type (N) and a doping level lower than that of the first doped region (25, 27, 75, 77), the epitaxial multilayer (21, 71) extending on the third doped region.

5. The electronic device according to any one of the preceding claims, further comprising an insulation structure (8, 9) that extends in the die (3) and surrounds, at least in part, the body structure (20, 70) of the first electronic component (5A, 5B).

6. The electronic device according to the preceding claim, wherein the insulation structure is a junction insulation structure or a deep-trench insulation structure.

7. The electronic device according to claim 5 or claim 6, wherein the body structure (20, 70) is delimited underneath, towards the substrate (15), by the first doped region (25, 75) and laterally by the insulation structure.

8. The electronic device according to any one of the preceding claims, further comprising a separation region (50, 100) that extends in the die and surrounds, at least in part, the epitaxial multilayer (21) and is arranged between the epitaxial multilayer and the body structure (20, 70), in particular in contact with the epitaxial multilayer and the body structure, the separation region comprising a region (53, 103) of semiconductor material of a polycrystalline type.

9. The electronic device according to any one of the preceding claims, further comprising a second electronic component (5B) based on heterostructure, the second electronic component comprising a respective body structure (70) of semiconductor material extending in the die, on the substrate (15), and a respective epitaxial multilayer (71) extending in contact with the body structure of the second electronic component and comprises a respective heterostructure (72),
the body structure (20) of the first electronic component (5A) being distinct from the body structure (70) of the second electronic component (5B), and the epitaxial multilayer (21) of the first electronic component extending at a distance from the epitaxial multilayer (71) of the second electronic component,
wherein the body structure of the second electronic component comprises a first doped region (75, 77) of semiconductor material extending between the respective heterostructure (72) and the substrate and having the second conductivity type (N).

10. The electronic device according to the preceding claim, wherein the first and second electronic components are HEMTs coupled together so as to form a circuit of the source-follower type.

11. The electronic device according to any one of the preceding claims, further comprising a third electronic component (10) that is based upon a single semiconductor material, for example silicon, and is integrated in the die (3).

12. A process for manufacturing an electronic device (1) comprising:
providing a wafer (150) comprising a substrate (15) of semiconductor material having a first conductivity type (P); and
forming, on the wafer, a first electronic component (5A, 5B) based on heterostructure,
wherein forming a first electronic component comprises:
forming a body structure (20, 70) of semiconductor material on the substrate (15); and
forming an epitaxial multilayer (21, 71) in contact with the body structure and comprising a heterostructure (21, 71),
wherein the body structure comprises a first doped region (25, 27, 75, 77) of semiconductor material extending between the heterostructure and the substrate and having a second conductivity type (N) different from the first conductivity type.

13. The manufacturing process according to the preceding claim, wherein the substrate is of silicon and has a top surface (15A), for example wherein the top surface is oriented according to the crystallographic direction <111>, and the body structure (20, 70) is formed via epitaxial growth of one or more layers on the top surface of the substrate.

14. The manufacturing process according to claim 12 or claim 13, wherein forming an epitaxial multilayer (21) comprises:
forming a growth mask (157) on an epitaxial layer (154) grown on the substrate (15), the growth mask comprising an oxide;
forming an opening in the growth mask, thereby exposing a central portion (154B) of the epitaxial layer; and
growing the epitaxial multilayer (21, 169) on the exposed portion of the epitaxial layer.

15. The process according to the preceding claim, wherein forming a growth mask comprises:
forming a mask layer (156) on the epitaxial layer;
removing part of the mask layer, thereby exposing a peripheral portion (154A) of the epitaxial layer; and
growing, on the epitaxial layer (154), a surface layer (160) of the same material as the epitaxial layer, the surface layer having a first portion (161) extending on the peripheral portion (154A) of the epitaxial layer (154) and a second portion (162) extending on the growth mask (157),
wherein forming an opening in the growth mask (157) further comprises forming, through the second portion (162) of the surface layer, a recess extending up to the growth mask.
